# EUROPEAN PATENT APPLICATION

(11) **EP 4 780 172 A1**
(43) Date of publication of application: **22.07.2026**
(21) Application number: 25224812.5
(22) Date of filing: 18.12.2025
(51) Int. Cl.: H10F 77/20, H10F 77/70, H10F 71/00

(54) **BACK-CONTACT SOLAR CELL AND PREPARATION METHOD THEREOF, AND PHOTOVOLTAIC MODULE**

(30) Priority: 17.01.2025 CN 202510073703
(71) Applicant: Tongwei Solar (Chengdu) Co., Ltd., Chengdu, Sichuan 610299 (CN)
(72) Inventor: ZHOU, Xu, Chengdu, 610299 (CN); GAN, Qin, Chengdu, 610299 (CN); MENG, Xiajie, Chengdu, 610299 (CN); XING, Guoqiang, Chengdu, 610299 (CN)
(74) Representative: Dehns Germany Partnerschaft mbB

(57) **Abstract**

The invention provides a back-contact solar cell and a preparation method thereof, and a photovoltaic module. The back-contact solar cell includes a crystalline silicon substrate (100) and a first functional film (110), the back side of the crystalline silicon substrate (100) is provided with a first region (101) and an isolation region (103), the isolation region (103 ) is disposed on one side of the first region (101); and the first functional film (110) is stacked on the first region (101), the first functional film (110) is provided with a light-trapping portion (1100) close to the isolation region (103), the light-trapping portion (1100) is provided with at least one of a light-trapping valley (1102) and a light-trapping peak (1101).

## Description

### Technical Field

The present invention relates to the technical field of photovoltaics, and particularly relates to a back-contact solar cell and a preparation method thereof, and a photovoltaic module.

### Background

Under actual working conditions of a back-contact solar cell, rays are not only incident towards the front side of the back-contact solar cell, but also are incident from the back side of the back-contact solar cell after being reflected. Although the back-contact solar cell can fully utilize the incident rays from the front side, the utilization efficiency of the rays being incident from the back side of the back-contact solar cell is relatively low, which limits the double-sided-utilization rate of the back-contact solar cell.

### Summary

The present invention provides a back-contact solar cell, including:
a crystalline silicon substrate, a back side of the crystalline silicon substrate is provided with a first region, a second region and an isolation region, the isolation region is disposed between the first region and the second region, and the first region and the second region are spaced apart by the isolation region;
a first functional film, the first functional film includes a first tunneling layer and a first doped layer, the first tunneling layer and the first doped layer are sequentially stacked on the first region, the first functional film is provided with a light-trapping portion close to the isolation region, the light-trapping portion is provided with at least one of a light-trapping valley and a light-trapping peak, and along a direction close to the crystalline silicon substrate, the light-trapping valley narrows, and the light-trapping peak expands outwardly; and
a second functional film, the second functional film includes a second tunneling layer and a second doped layer, the second tunneling layer and the second doped layer are sequentially stacked on the second region, and the second doped layer and the first doped layer have opposite doping types.

In some embodiments of the present invention, the light-trapping portion includes a plurality of light-trapping peaks, the plurality of light-trapping peaks are continuously disposed, and bottommost ends of side walls of two adjacent light-trapping peaks of the plurality of light-trapping peaks are connected.

In some embodiments of the present invention, the first functional film has a first boundary close to the isolation region, the second functional film has a second boundary close to the isolation region, and a fluctuation variance of a spacing of the first boundary relative to a center line of the isolation region is greater than a fluctuation variance of a spacing of the second boundary relative to the center line of the isolation region.

In some embodiments of the present invention, a value of the fluctuation variance of the first boundary is in a range of 30 to 100.

In some embodiments of the present invention, a height difference between an end portion of the light-trapping portion that is closest to the crystalline silicon substrate and a top surface of the first functional film is in a range of 0.5 µm to 6 µm.

In some embodiments of the present invention, a height difference between an end portion of the light-trapping portion that is closest to the crystalline silicon substrate and the top surface of the first functional film is in a range of 3 µm to 6 µm.

In some embodiments of the present invention, a surface of the isolation region of the crystalline silicon substrate has a textured structure, and a height difference between a bottommost end of the light-trapping portion and a top surface of the first functional film is greater than a height difference between a bottommost end of the insolation region adjacent to the light-trapping portion and the top surface of the first functional film.

In some embodiments of the present invention, a doping type of the first doped layer is an N type, and a doping type of the second doped layer is a P type.

In some embodiments of the present invention, the first functional film further includes at least one of a first passivation layer and a first anti-reflection layer which are stacked on the first doped layer; and/or,
the second functional film further includes at least one of a second passivation layer and a second anti-reflection layer which are stacked on the second doped layer.

In some embodiments, the present invention further provides a preparation method of the back-contact solar cell in accordance with any of the above embodiments, including the following steps:
sequentially forming the second tunneling layer and the second doped layer on the second region of the crystalline silicon substrate, and sequentially forming the first tunneling layer, the first doped layer and a first doped oxide layer on the first region of the crystalline silicon substrate,
the first doped oxide layer is provided with a light-trapping process region close to the isolation region,
removing a portion of the first doped oxide layer in the light-trapping process region, and exposing the first doped layer disposed below the light-trapping process region; and
etching the first doped oxide layer, the first doped layer and the first tunneling layer by using an alkaline solution, so as to form the light-trapping portion.

In some embodiments of the present invention, removing the portion of the first doped oxide layer in the light-trapping process region includes: scanning the light-trapping process region by using target laser, wherein
during scanning the light-trapping process region by using target laser, a light spot of the target laser includes a higher-energy region and a lower-energy region, the power density of the higher-energy region is greater than 0.25 J/cm2, and the power density of the lower-energy region is less than or equal to 0.25 J/cm2; or,
during scanning the light-trapping process region by using target laser, the target laser is controlled to only scan a partial region of the light-trapping process region.

In some embodiments of the present invention, in a step of forming the first tunneling layer and the first doped layer on the crystalline silicon substrate, the first tunneling layer, the first doped layer and the first doped oxide layer are epitaxially deposited on the isolation region; and
the preparation method further includes performing laser ablation in the isolation region to remove the first doped oxide layer disposed on the isolation region.

In some embodiments of the present invention, in a step of etching the first tunneling layer and the first doped layer by using the alkaline solution, a texturing agent is used as the alkaline solution, and meanwhile a texturing treatment is performed on a front side and the back side of the crystalline silicon substrate by using the texturing agent.

In some embodiments, the present invention further provides a photovoltaic module, the photovoltaic module includes the back-contact solar cell in accordance with the above embodiments, or the photovoltaic module includes the back-contact solar cell prepared by the preparation method of the back-contact solar cell in accordance with the above embodiments.
inventionThe above description is only an overview of the technical solutions of the present invention, and in order to more clearly understand the technical means of the present invention and to implement same in accordance with the content of the specification, a detailed description will be given below with accompanying preferred embodiments of the present invention and in accordance with drawings.

### Brief Description of the Drawings

To illustrate technical solutions in the embodiments of the present invention more clearly, a brief introduction to the drawings which are needed in the description of the embodiments is given below. Apparently, the drawings in the description below are merely some of the embodiments of the present invention, and for those ordinary skilled in the art, the drawings of other embodiments are obtained in accordance with these drawings without any creative effort.
Fig. 1 is a schematic cross-sectional view of a back-contact solar cell in accordance with one or more embodiments;
Fig. 2A is a partial schematic cross-sectional view of a first functional film including a light-trapping portion in Fig. 1;
Fig. 2B illustrates an optical pathway of incident rays shown in Fig. 2A;
Fig. 3 is a schematic top-view of a partial cross-sectional structure of a first functional film, an isolation region and a second functional film in Fig. 1;
Fig. 4 is a flowchart of steps of a preparation method of a back-contact solar cell;
Fig. 5 is a schematic view of a cross-sectional structure of depositing a second tunneling layer and a second doped layer on a crystalline silicon substrate;
Fig. 6 is a schematic structural view of removing the second tunneling layer and the second doped layer outside a second region on the basis of the structure shown in Fig. 5;
Fig. 7 is a schematic structural view of depositing a first tunneling layer and a first doped layer on the basis of the structure shown in Fig. 6;
Fig. 8 is a schematic view of controlling energy density distribution of a light spot of target laser;
Fig. 9 is a schematic structural view of controlling a scanning region of the target laser;
Fig. 10 is a schematic view of a cross-sectional structure after the structure shown in Fig. 7 is etched by an alkaline solution;
Fig. 11 is a partial enlarged top view including a light-trapping portion in Embodiment 1;
Fig. 12 is a top view of an isolation region; and
Fig. 13 is a schematic view of a cross-sectional structure of an isolation region having a light-trapping portion.

The reference signs and meanings thereof are as follows:
100, crystalline silicon substrate; 1001, first boundary; 1002, second boundary; 101, first region; 102, second region; 103, isolation region; 110, first functional film; 1100, light-trapping portion; 1101, light-trapping peak; 1102, light-trapping valley; 1103, side wall; 111, first tunneling layer; 112, first doped layer; 113, first passivation layer; 114, first anti-reflection layer; 120, second functional film; 121, second tunneling layer; 122, second doped layer; 123, second passivation layer; 124, second anti-reflection layer; 130, front-side passivation layer; 140, front-side anti-reflection layer; 150, first electrode; 160, second electrode; 210, first doped oxide layer; 220, second doped oxide layer; 301, light-trapping process region; 310, target laser; 311, higher-energy region; 312, lower-energy region.

### Detailed Description of the Embodiments

For ease of understanding this invention, a more comprehensive description will be given herein below. Preferred embodiments are provided herein. However, this invention is implemented in many different forms and is not limited to the embodiments described herein. On the contrary, the purpose of providing these embodiments is to make the content of the invention more thorough and comprehensive.

Unless otherwise defined, all technical and scientific terms used herein have the same meanings as commonly understood by those skilled in the art belonging to this invention. The terms used in the specification herein are for the purpose of describing particular embodiments only and are not intended to limit this invention.

It should be understood that when an element or a layer is referred to as being "on", "adjacent to", "connected to" or "coupled to" another element or layer, it is directly on the other element or layer, or be adjacent to, connected to or coupled to the other element or layer, or there is an intervening element or layer. In contrast, when an element is referred to as being "directly on", "directly adjacent to", "directly connected to" or "directly coupled to" another element or layer, there is no intervening element or layer. It should be understood that although the terms first, second, third or the like are used for describing various elements, components, regions, layers and/or portions, these elements, components, regions, layers and/or portions should not be limited by these terms. These terms are only used for distinguishing one element, component, region, layer or portion from another element, component, region, layer or portion.

Spatial relation terms, such as "under", "below", "beneath", "at the lower side of", "above" and "on", are used herein for the ease of description to describe the relationship between one element or feature and another element or feature. It should be understood that the spatial relation terms are also intended to include different orientations of a device in use and operation. For example, if a device in the figures is turned over, then an element or feature described as being "under", "below" or "beneath" another element or feature would then be oriented as being "on" the other element or feature. Thus, exemplary terms "below" and "under" may include both upper and lower orientations. The device may be otherwise oriented (e.g., rotated 90 degrees or orientated otherwise) and the spatial description terms used are interpreted accordingly.

The terms used herein are for the purpose of describing particular embodiments only and are not intended to limit the present invention. As used herein, singular forms "a", "an" and "the" are intended to include plural forms as well, unless the context clearly dictates otherwise. It should also be understood that, when used in the specification, the terms "composed of" and/or "include" determine the presence of features, integers, steps, operations, elements and/or components, but do not preclude the presence or addition of one or more other features, integers, steps, operations, elements, components, and/or groups. As used herein, the term "and/or" includes any and all combinations of related listed items.

The back-contact solar cell includes the crystalline silicon substrate in the present invention, the first functional film and a second functional film, and the back side of the crystalline silicon substrate is provided with a first region, a second region and an isolation region, the isolation region is disposed between the first region and the second region, and the first region and the second region are spaced apart by the isolation region. The first functional film includes a first tunneling layer and a first doped layer, the first tunneling layer and the first doped layer are sequentially stacked on the first region, the light-trapping portion is provided in the first functional film close to the isolation region, wherein the light-trapping portion includes at least one of a light-trapping valley and a light-trapping peak, the light-trapping peak refers to a protruding structure that is disposed on the crystalline silicon substrate and takes the shape of a pointed top or an approximately pointed top. In some embodiments, the light-trapping valley is immediately adjacent to the light-trapping peak and take the shape of an elongated channel, or the light-trapping valley is spaced apart from the light-trapping peak and take the shape of a groove. The second functional film includes a second tunneling layer and a second doped layer, the second tunneling layer and the second doped layer are sequentially stacked on the second region, and the second doped layer and the first doped layer have opposite doping types.

The crystalline silicon substrate is disposed in the back-contact solar cell of the present invention, the first functional film and the second functional film are stacked on the crystalline silicon substrate, the first functional film and the second functional film are respectively used for transporting two different electrical types of carriers, the first functional film is provided with the light-trapping portion close to the isolation region, and the light-trapping portion includes the light-trapping valley and the light-trapping peak, along a direction close to the crystalline silicon substrate, both the narrowing light-trapping valley and the outwardly expanding light-trapping peak reduce the reflectivity of rays being incident from the back side of the back-contact solar cell towards the interior of the first functional film and the crystalline silicon substrate, thereby improving the utilization rate of the rays being incident from the back side of the back-contact solar cell by the crystalline silicon substrate, so as to achieve a light-trapping effect and increase the utilization rate of the crystalline silicon substrate for the rays being incident from the back side, which can effectively increase the double-sided-utilization rate of the back-contact solar cell, so that the efficiency of the back-contact solar cell is further improved.

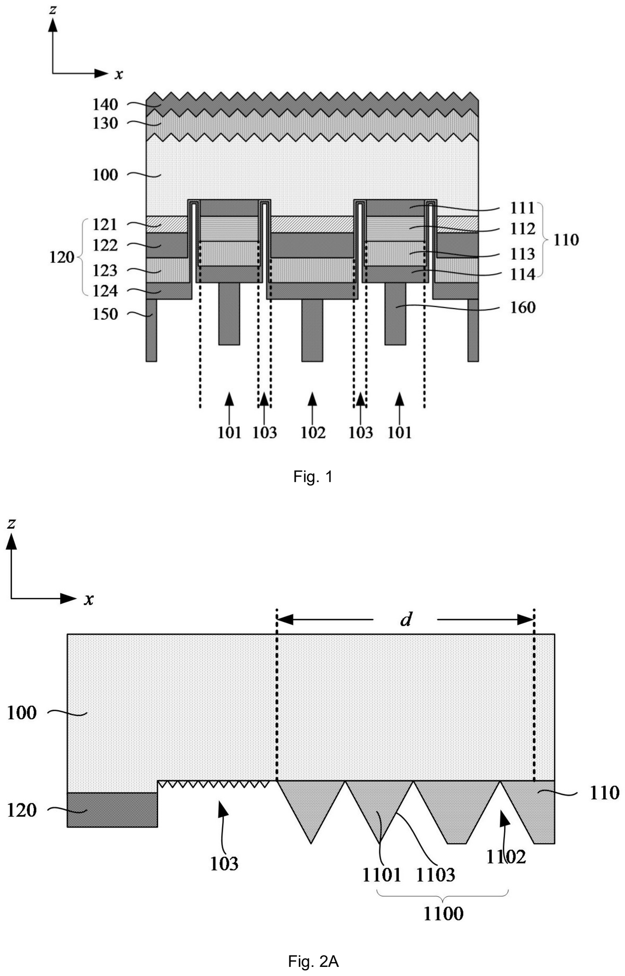

Fig. 1 is a schematic cross-sectional view of a back-contact solar cell in accordance with the present invention. As shown in Fig. 1, the back-contact solar cell includes a crystalline silicon substrate 100, a first functional film 110 and a second functional film 120. The back side of the crystalline silicon substrate 100 is provided with a first region 101, a second region 102 and an isolation region 103, and the isolation region 103 is disposed between the first region 101 and the second region 102. The first functional film 110 is stacked on the first region 101, and the second functional film 120 is stacked on the second region 102.

It can be understood that carriers of one conduction type in photon-generated carriers generated in the crystalline silicon substrate 100 are transported out of the first region 101, and carriers of another conduction type are transported out of the second region 102.

As shown in Fig. 1, it can be understood that the first functional film 110 and the second functional film 120 are spaced apart by the isolation region 103. A doping type in the first functional film 110 is different from a doping type in the second functional film 120. The first functional film 110 and the second functional film 120 are respectively used for transporting carriers of different conduction types from the crystalline silicon substrate 100. Moreover, the first functional film 110 and the second functional film 120 are further used for passivating the surface of the crystalline silicon substrate 100, thereby reducing interfacial recombination losses of the carriers between the crystalline silicon substrate and the doped layer.

As shown in Fig. 1, as some examples of the embodiments, the crystalline silicon substrate 100 has a plurality of first regions 101 and a plurality of second regions 102, and each of the plurality of first regions 101 and an adjacent second region 102 are spaced apart by the isolation region 103. Each of the plurality of first regions 101 is provided with the first functional film 110, and each of the plurality of second regions 102 is provided with the second functional film 120.

Fig. 2A is a partial schematic cross-sectional view of the first functional film 110 including a light-trapping portion 1100. As shown in Fig. 2A, the light-trapping portion 1100 is disposed close to the isolation region 103, and the light-trapping portion 1100 is provided with at least one of a light-trapping valley 1102 and a light-trapping peak 1101, along a direction close to the crystalline silicon substrate 100, the light-trapping valley 1102 narrows, and the light-trapping peak 1101 expands outwardly.

As shown in Fig. 2A, as some examples of the embodiments, the light-trapping portion 1100 is simultaneously provided with the light-trapping valley 1102 and the light-trapping peak 1101, so as to further enhance the light-trapping performance of the first functional film 110 for rays.

As shown in Fig. 2A, as some examples of the embodiments, the light-trapping portion 1100 includes a plurality of light-trapping peaks 1101, the plurality of light-trapping peaks 1101 are continuously disposed, and bottommost ends of side walls 1103 of two adjacent light-trapping peaks 1101 of the plurality of light-trapping peaks 1101 are connected, and the plurality of light-trapping peaks 1101 form a zigzag-shaped structure in a direction along the surface of the crystalline silicon substrate 100. Compared with a single light-trapping peak 1101, two adjacent side walls of the plurality of light-trapping peaks 1101 further enhance, by means of back-and-forth reflection, the absorption rate of the light-trapping portion 1100 for rays being incident from the back side of the back-contact solar cell.

In the example, the top end of a single light-trapping peak 1101 takes the shape of a pointed top, that is, the top end of the light-trapping peak 1101 is dot-shaped or line-shaped. When the top end of the single light-trapping peak 1101 is line-shaped, the entirety of the light-trapping peaks 1101 takes the shape of a ridge, and when the top end of the single light-trapping peak 1101 is dot-shaped, the entirety of the light-trapping peaks 1101 takes the shape of a mountain peak.

As shown in Fig. 2A, as some examples of the embodiments, a height difference between the end portion of the light-trapping portion 1100 that is closest to the crystalline silicon substrate 100 and a top surface of the first functional film 110 is in a range of 0.5 µm to 6 µm, for example, the height difference between the end portion of the light-trapping portion 1100 that is closest to the crystalline silicon substrate 100 and the top surface of the first functional film 110 is 2 µm, 2.5 µm, 3 µm, 3.5 µm, 4 µm, 5 µm and 6 µm, or the height difference between the end portion of the light-trapping portion 1100 that is closest to the crystalline silicon substrate 100 and the top surface of the first functional film 110 is between any two numerical values of the above height difference values.

It can be understood that the top end of the light-trapping portion 1100 is an end in the overall structure of the light-trapping portion 1100 that is farthest away from the crystalline silicon substrate 100, and the bottommost end of the light-trapping portion 1100 is an end in the overall structure of the light-trapping portion 1100 that is closest to the crystalline silicon substrate 100.

In some embodiments, the height difference between the end portion of the light-trapping portion 1100 that is closest to the crystalline silicon substrate 100 and the top surface of the first functional film 110 is in a range of 3 µm to 6 µm, for example, the height difference between the end portion of the light-trapping portion 1100 that is closest to the crystalline silicon substrate 100 and the top surface of the first functional film 110 is 3 µm, 3.5 µm, 4 µm, 5 µm and 6 µm, or the height difference between the end portion of the light-trapping portion 1100 that is closest to the crystalline silicon substrate 100 and the top surface of the first functional film 110 is between any two numerical values of the above height difference values. The height difference is obviously greater than the height of a general pyramid-textured structure, in this way, the trapping area of the light-trapping portion 1100 for the rays being incident from the back side of the cell can be further increased, thereby improving the utilization rate of the crystalline silicon substrate 100 for the incident rays.

As shown in Fig. 2A, as some examples of the embodiments, the surface of the isolation region 103 of the crystalline silicon substrate 100 has a textured structure. It can be understood that the textured structure is uneven, and an overall structure of the textured structure has a top end farthest away from the crystalline silicon substrate 100 and a bottommost end closest to the crystalline silicon substrate 100. A height difference between the bottommost end of the light-trapping portion 1100 and the top surface of the first functional film 110 is greater than a height difference between the bottommost end of the isolation region 103 adjacent to light-trapping portion 1100 and the top surface of the first functional film 110.

As some examples of the embodiments, the distance between the top end of each light-trapping peak 1101 and the bottommost end thereof is in a range of 0.5 µm to 6 µm. By using the light-trapping peak 1101 having the above height range, the area proportion of the first functional film 110 on the back side of the cell can be improved as much as possible while providing better light-trapping performance, thereby ensuring that the first functional film 110 still has better passivation performance and carrier collection performance.

In the example, a height difference between the top end of the light-trapping peak 1101 and the bottommost end thereof is any one of 2 µm, 2.5 µm, 3 µm, 3.5 µm, 4 µm, 5 µm and 6 µm, or the height difference between the top end of the light-trapping peak 1101 and the bottommost end thereof is in the range of any two numerical values of the above height difference values. It can be understood that the heights of the plurality of light-trapping peaks 1101 are the same or different.

Fig. 2A shows one cross section of the light-trapping valley 1102, it can be understood that the entire light-trapping valley 1102 takes the shape of a cone or a pyramid, that is, the notch bottom of the light-trapping valley 1102 takes the shape of a pointed bottom.

As some examples of the embodiments, the light-trapping portion 1100 includes a light-trapping valley 1102 and a light-trapping peak 1101, and the light-trapping valley 1102 is disposed on the side of the light-trapping peak 1101 that is away from the isolation region 103.

As some examples of the embodiments, a plurality of light-trapping valleys 1102 are disposed in the light-trapping portion 1100, and two adjacent light-trapping valleys 1102 are disposed adjacent to each other or spaced apart from each other.

As some examples of the embodiments, the depth of the light-trapping valley 1102 is in a range of 0.5 µm to 6 µm. In some embodiments, the depth of the light-trapping valley 1102 is any one of 2 µm, 2.5 µm, 3 µm, 3.5 µm, 4 µm, 5 µm and 6 µm, or the depth of the light-trapping valley 1102 is in a range of any two numerical values of the above depth values.

It can be understood that Fig. 2A shows a partial cross-sectional structure from the isolation region 103 towards an extension direction (i.e. an x direction in Fig. 1) of the first region 101, which shows only one light-trapping portion 1100. As some examples of the embodiments, the first functional film 110 includes a plurality of light-trapping portions 1100, and all the plurality of light-trapping portions 1100 are close to the isolation region 103 and are spaced apart from each other.

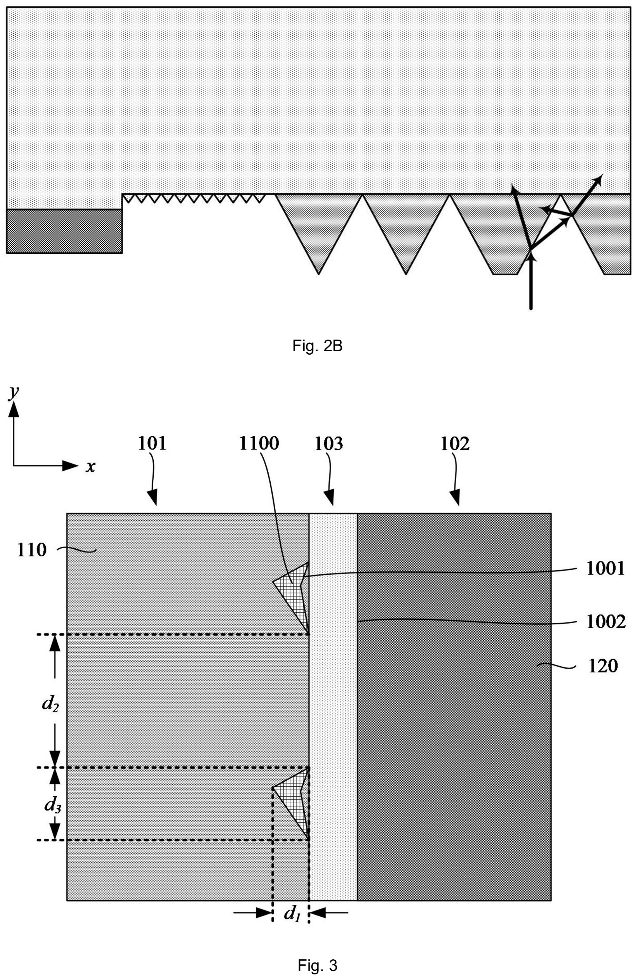

Fig. 2B illustrates an optical pathway of incident rays shown in Fig. 2A. Solid lines with arrows in Fig. 2B represent the incident rays. As shown in Fig. 2B, when the incident rays are irradiated onto a side wall 1103 of the light-trapping peak 1101, a portion of the incident rays passes through the light-trapping peak 1101 and enters into the crystalline silicon substrate 100 to be absorbed by the crystalline silicon substrate 100, the other portion of the incident rays is reflected on the side wall of the light-trapping peak 1101 towards a direction close to the crystalline silicon substrate 100 and then is absorbed by the crystalline silicon substrate 100. In addition, compared with the general pyramid-textured structure, a height dimension of the light-trapping peak 1101 in the embodiments is obviously greater, and a depth dimension of the light-trapping valley 1102 is also obviously greater, which is also conducive to enabling more incident rays to be refracted or reflected by the light-trapping peak 1101 and the light-trapping valley 1102. Therefore, the light-trapping portion 1100 having the light-trapping peak 1101 and the light-trapping valley 1102 can significantly improve the absorption rate of the incident rays.

Fig. 3 shows a schematic top-view of a partial cross-sectional structure of the first functional film 110, the isolation region 103 and the second functional film 120 in Fig. 1. In the embodiments, the extension direction (i.e., a y direction in Fig. 3) of a boundary line between the first region 101 and the isolation region 103 is perpendicular to a plane the cross section in Fig. 1 is disposed. As shown in Fig. 3, a plurality of light-trapping portions 1100 are sequentially disposed along the boundary line between the first region 101 and the isolation region 103, the plurality of light-trapping portions 1100 can further improve the absorption rate of the back side of the crystalline silicon substrate 100 for rays, and the plurality of light-trapping portions 1100 disposed at intervals can improve the area proportion of the light-trapping portion 1100 on the back side of the cell while reducing the damage to the first functional film 110, thereby ensuring that the first functional film 110 still has better carrier collection performance. In addition, if the entire edge of the first functional film 110 close to the isolation region 103 is designed to be the light-trapping portion 1100, although a better ray absorption rate can be obtained to generate more carriers, the proportion of the first functional film 110 is reduced, thus reducing the carrier collection performance.

It can be understood that the light-trapping portion 1100 has an end farthest away from the isolation region 103, and the end of the light-trapping portion 1100 that is farthest away from the isolation region 103 is determined in accordance with at least one of the light-trapping valley 1102 and the light-trapping peak 1101 farthest away from the isolation region 103. As shown in Fig. 3, the spacing between the end of the light-trapping portion 1100 that is farthest away from the isolation region 103 and the isolation region 103 is d₁. As some examples of the embodiments, the spacing value d₁ between the end of the light-trapping portion 1100 that is farthest away from the isolation region 103 and the isolation region 103 is less than or equal to 25 µm, for example, the spacing value d₁ between the end of the light-trapping portion 1100 that is farthest away from the isolation region 103 and the isolation region 103 is 5 µm, 10 µm, 15 µm, 20 µm and 25 µm, or the spacing d₁ between the end of the light-trapping portion 1100 that is farthest away from the isolation region 103 and the isolation region 103 is in a range of any two numerical values of the above spacing values. By using the design of the light-trapping portion 1100 having the specific spacing range, better light absorption performance can be balanced out, and it is conducive to maintaining better carrier collection performance of the first functional film 110, so that that the efficiency of the back-contact solar cell can be improved more significantly.

As shown in Fig. 3, the spacing value between two adjacent light-trapping portions 1100 is d₂, that is, there is a spacing value with a length of d₂ between a tail end of the previous light-trapping portion 1100 and a head end of the latter light-trapping portion 1100. As some examples of the embodiments, the spacing value d₂ between two adjacent light-trapping portions 1100 is 20 µm to 200 µm, and the first functional film 110 disposed between the two adjacent light-trapping portions 1100 can maintain a complete passivation contact structure. By using the design of the light-trapping portions having the specific spacing value, better light absorption performance can be balanced out, and it is conducive to ensuring the carrier collection performance of the first functional film 110, so that the efficiency of the back-contact solar cell is improved more significantly.

In the example, the spacing value between the two adjacent light-trapping portions 1100 is any one of 20 µm, 30 µm, 50 µm, 70 µm, 100 µm, 120 µm, 150 µm, 170 µm and 200 µm, or the spacing between the two adjacent light-trapping portions 1100 is in a range of any two numerical values of the above spacing values.

As shown in Fig. 3, along the extension direction of the boundary between the first region 101 and the isolation region 103, a single light-trapping portion 1100 has a length d₃. As some examples of the embodiments, the length d₃ of the single light-trapping portion 1100 is in a range of 10 µm to 90 µm. In the example, the length of the single light-trapping portion 1100 is any one of 10 µm, 20 µm, 30 µm, 40 µm, 50 µm, 60 µm, 70 µm, 80 µm and 90 µm, or the length of the single light-trapping portion 1100 is in a range of any two numerical values of the above length values.

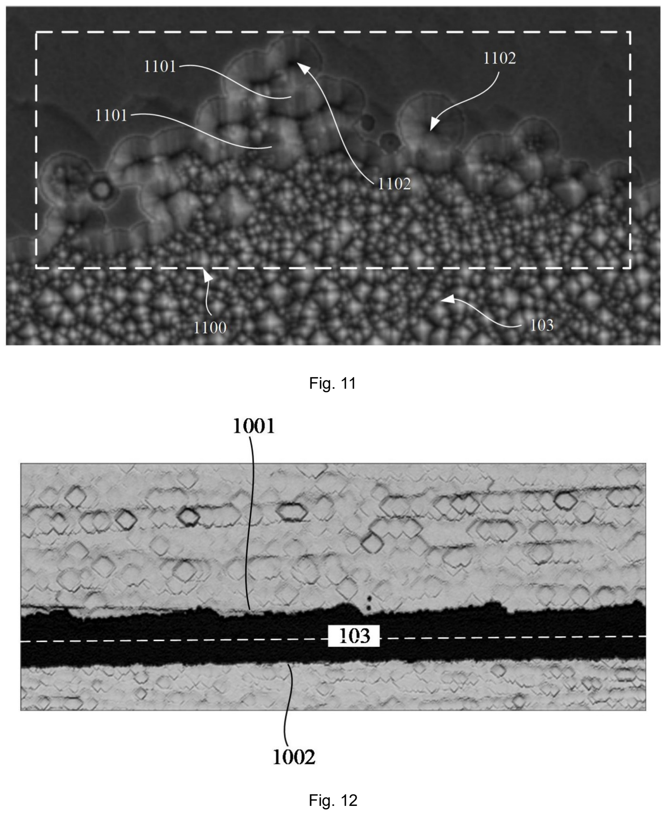

As shown in Fig. 3 and Fig. 12, the first functional film 110 has a first boundary 1001 close to the isolation region 103, the second functional film 120 has a second boundary 1002 close to the isolation region 103, and an overall fluctuation variance of the first boundary 1001 is greater than an overall fluctuation variance of the second boundary 1002, the "fluctuation variance" of the first boundary 1001 and the second boundary 1002 should be understood as the deviation degree of the first boundary 1001 relative to the extension direction of the isolation region 103. It can be understood that since the first functional film 110 is provided with the light-trapping portion 1100 at the first boundary 1001 close to the isolation region 103, the overall fluctuation variance of the first boundary 1001 is greater than the overall fluctuation variance of the second boundary 1002.

As some examples, the value of the fluctuation variance of the first boundary 1001 is in a range of 30 to 100, by using the design of the first boundary having the specific fluctuation variance range, better light absorption performance can be balanced out, and it is conducive to ensuring the carrier collection performance of the first functional film 110, so that the efficiency of the back-contact solar cell is improved more significantly. As some examples, the "fluctuation variance" of the first boundary 1001 is determined in the following manner: firstly, select an isolation region 103 with a length ranging from 100 µm to 500 µm, and select a plurality of uniformly distributed points on the entirety of the first boundary 1001, part of points should be disposed at the light-trapping portion 1100 among the plurality of points, meanwhile select a reference line which is disposed in a central region of the isolation region 103 and is substantially parallel to the extension direction of the isolation region 103; secondly, respectively acquire the distances of the plurality of points on the first boundary 1001 relative to the reference line, and calculate a variance of these acquired distances, the greater the variance is, the greater the distribution deviation of these distances are, that is, the greater the fluctuation variance of the first boundary 1001 is. The fluctuation variance of the second boundary 1002 is acquired by using the same method.

As some examples of the embodiments, the first functional film 110 includes a first tunneling layer 111 and a first doped layer 112, and the first tunneling layer 111 and the first doped layer 112 are sequentially stacked on the first region 101 of the crystalline silicon substrate 100, the first tunneling layer 111 is used for spacing the first doped layer 112 apart from the crystalline silicon substrate 100, the first tunneling layer 111 is used for allowing carriers to pass through while passivating the crystalline silicon substrate 100, and the first doped layer 112 is used for selectively collecting the carriers.

As some examples of the embodiments, the material of the first tunneling layer 111 is selected from one or more of amorphous silicon, intrinsic amorphous silicon, hydrogenated amorphous silicon, hydrogenated intrinsic amorphous silicon or silicon oxide.

As some examples of the embodiments, the thickness of the first tunneling layer 111 is ranging from 1 nm to 3 nm.

As some examples of the embodiments, the doping type of the first doped layer 112 is an N type. In some embodiments, a doping element in the first doped layer 112 is a phosphorus element. The N-type doped film layer is more conducive to preparing the light-trapping portion 1100 in an actual process.

As some examples of the embodiments, the material of the first doped layer 112 includes doped polycrystalline silicon.

As some examples of the embodiments, the thickness of the first doped layer 112 is ranging from 100 nm to 400 nm.

As some examples of the embodiments, the second functional film 120 includes a second tunneling layer 121 and a second doped layer 122, and the second tunneling layer 121 and the second doped layer 122 are sequentially stacked on the second region 102 of the crystalline silicon substrate 100, the second tunneling layer 121 is used for spacing the second doped layer 122 apart from the crystalline silicon substrate 100, the second tunneling layer 121 is used for allowing carriers to pass through while passivating the crystalline silicon substrate 100, and the second doped layer 122 is used for selectively collecting the carriers.

As some examples of the embodiments, the material of the second tunneling layer 121 is selected from one or more of amorphous silicon, intrinsic amorphous silicon hydrogenated amorphous silicon, hydrogenated intrinsic amorphous silicon or silicon oxide.

As some examples of the embodiments, the thickness of the second tunneling layer 121 is ranging from 1 nm to 3 nm.

As some examples of the embodiments, the doping type of the second doped layer 122 is a P type. In some embodiments, the doping element in the second doped layer 122 is a boron element.

As some examples of the embodiments, the material of the second doped layer 122 includes doped polycrystalline silicon.

As some examples of the embodiments, the thickness of the second doped layer 122 is in a range of 100 nm to 400 nm.

As shown in Fig. 1, as some examples of the embodiments, the first functional film 110 further includes at least one of a first passivation layer 113 and a first anti-reflection layer 114, and the first passivation layer 113 and the first anti-reflection layer 114 are stacked on the first doped layer 112 and cover the first doped layer 112. In a case where the first functional film 110 includes the first passivation layer 113 and the first anti-reflection layer 114, the first anti-reflection layer 114 disposed on a side of the first passivation layer 113 away from the crystalline silicon substrate 100.

As shown in Fig. 1, as some examples of the embodiments, the second functional film 120 further includes at least one of a second passivation layer 123 and a second anti-reflection layer 124, and the second passivation layer 123 and the second anti-reflection layer 124 are stacked on the second doped layer 122 and cover the second doped layer 122. In a case where the second functional film 120 includes the second passivation layer 123 and the second anti-reflection layer 124, the second anti-reflection layer 124 disposed on a side of the second passivation layer 123 away from the crystalline silicon substrate 100.

As some examples of the embodiments, the first passivation layer 113 and the second passivation layer 123 are of an integrated structure, and the material of the first passivation layer 113 and the second passivation layer 123 includes aluminum oxide. In some embodiments, an integral layer composed of the first passivation layer 113 and the second passivation layer 123 covers the isolation region 103.

As some examples of the embodiments, the first anti-reflection layer 114 and the second anti-reflection layer 124 are of an integrated structure, and the material of the first anti-reflection layer 114 and the second anti-reflection layer 124 includes hydrogenated silicon nitride, hydrogenated silicon oxynitride or a combination thereof. In some embodiments, an integral layer composed of the first anti-reflection layer 114 and the second anti-reflection layer 124 cover the isolation region 103.

As shown in Fig. 1, as some examples of the embodiments, the back-contact solar cell further includes a front-side passivation layer 130, and the front-side passivation layer 130 is stacked on the side of the crystalline silicon substrate 100 that is away from the first functional film 110 and the second functional film 120.

As some examples of the embodiments, the material of the front-side passivation layer 130 includes aluminum oxide.

As shown in Fig. 1, as some examples of the embodiments, the back-contact solar cell further includes a front-side anti-reflection layer 140, the front-side anti-reflection layer 140 is stacked on the side of the front-side passivation layer 130 that is away from the crystalline silicon substrate 100, and the front-side anti-reflection layer 140 covers the front-side passivation layer 130.

As some examples of the embodiments, the material of the front-side anti-reflection layer 140 includes one or a combination of two of hydrogenated silicon nitride and hydrogenated silicon oxynitride.

As shown in Fig. 1, as some examples of the embodiments, the back-contact solar cell further includes a first electrode 150 and a second electrode 160, both the first electrode 150 and the second electrode 160 are disposed on the back side of the crystalline silicon substrate 100, the first electrode 150 is disposed on the first region 101 and is electrically connected to the first doped layer 112, and the second electrode 160 is disposed on the second region 102 and is electrically connected to the second doped layer 122.

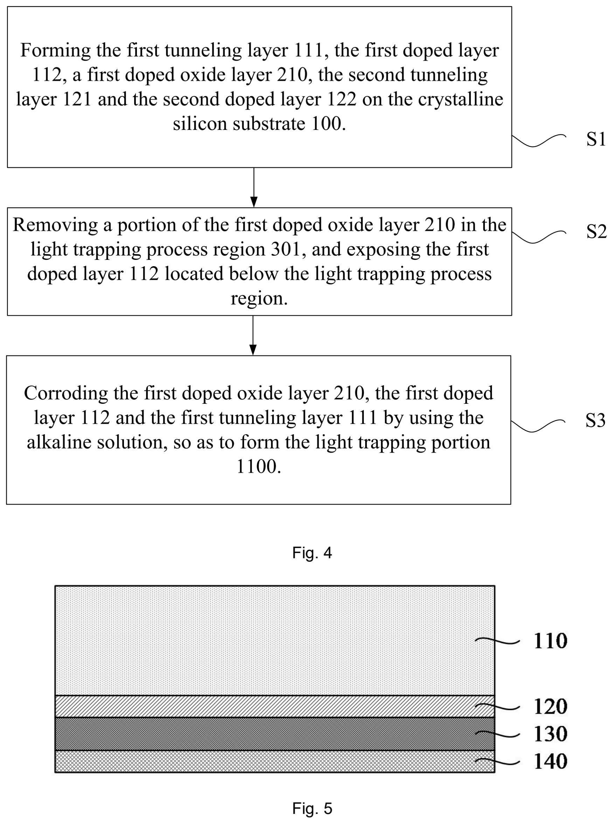

The present invention further provides a preparation method of the back-contact solar cell in the above embodiments. Fig. 4 is a schematic flowchart of steps of the preparation method of the back-contact solar cell. As shown in Fig. 4, the preparation method includes steps S1-S3.

Step S1, forming the first tunneling layer 111, the first doped layer 112, a first doped oxide layer 210, the second tunneling layer 121 and the second doped layer 122 on the crystalline silicon substrate 100.

As some examples of the embodiments, a crystalline silicon material is used as the crystalline silicon substrate 100.

As some examples of the embodiments, the second tunneling layer 121 and the second doped layer 122 are formed prior to the first tunneling layer 111 and the first doped layer 112, which makes subsequent procedures of forming the light-trapping portion 1100 on the first tunneling layer 111 and the first doped layer 112 simpler.

As some examples of the embodiments, forming the second tunneling layer 121 and the second doped layer 122 includes: depositing the second tunneling layer 121 and the second doped layer 122 on a semiconductor, and performing patterning on the deposited second tunneling layer 121 and the second doped layer 122.

Fig. 5 is a schematic view of a cross-sectional structure of depositing the second tunneling layer 121 and the second doped layer 122 on the crystalline silicon substrate 100. As shown in Fig. 5, in the embodiments, the deposited second tunneling layer 121 and the second doped layer 122 cover the first region 101, the second region 102 and the isolation region 103 on the back side of the crystalline silicon substrate 100.

As some examples of the embodiments, the second tunneling layer 121 and the second doped layer 122 include second tunneling layers 121 and second doped layers 122, which are stacked in sequence.

As some examples of the embodiments, forming the second tunneling layer 121 and the second doped layer 122 includes: sequentially depositing the second tunneling layer 121, a silicon material layer and a second doped oxide layer 220 by means of a chemical vapor deposition method, and performing heating to enable a doping element in the second doped oxide layer 220 to diffuse into the silicon material layer, so as to form the second doped layer 122, the chemical vapor deposition method specifically is low pressure chemical vapor deposition (LPCVD) or plasma enhanced chemical vapor deposition (PECVD).

For example, in the example, the material of the second doped oxide layer 220 is borosilicate glass, due to the heating, a boron element in the borosilicate glass diffuses into the silicon material layer to form P-type doped polycrystalline silicon, which serves as the second doped layer 122.

As some other examples of the embodiments, forming the second tunneling layer 121 and the second doped layer 122 includes: sequentially depositing the second tunneling layer 121 and the second doped layer 122 by means of the chemical vapor deposition method, the chemical vapor deposition method specifically is LPCVD or PECVD, the second tunneling layer 121 and the second doped layer 122 are successively deposited in the same deposition chamber, and after the second doped layer 122 is deposited, a second doped oxide layer 220 is deposited.

It can be understood that the deposited second tunneling layer 121 and the deposited second doped layer 122 not only cover the second region 102 on the back side of the crystalline silicon substrate 100, but also extend to cover the first region 101 and the isolation region 103. As some examples of these embodiments, after the second tunneling layer 121 and the second doped layer 122 are deposited, the method further includes performing patterning onto the second tunneling layer 121 and the second doped layer 122, so as to remove the second tunneling layer 121 and the second doped layer 122 outside the second region 102. In the embodiments, the pre-formed second doped oxide layer 220 can also serve as a mask in a subsequent patterning process.

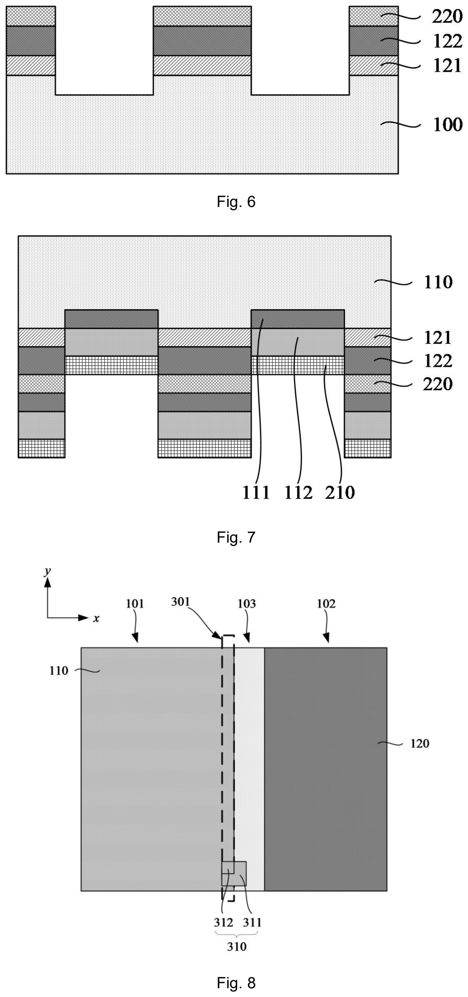

Fig. 6 is a schematic structural view of removing the second tunneling layer 121 and the second doped layer 122 outside the second region 102 on the basis of the structure shown in Fig. 5. As shown in Fig. 6, only the second tunneling layer 121 and the second doped layer 122 disposed on the second region 102 are reserved, and the first region 101 and the isolation region 103 of the crystalline silicon substrate 100 are exposed from openings of the second tunneling layer 121 and the second doped layer 122.

As some examples of the embodiments, the manner of performing the patterning onto the second tunneling layer 121 and the second doped layer 122 includes: performing ablation by using target laser 310 to remove the second doped oxide layer 220 on the first region 101 and the isolation region 103, and then performing etching by using an alkaline solution to remove the second doped layer 122 and the second tunneling layer 121 which are exposed from the ablation region of the target laser 310.

In some embodiments, in a step of etching the second doped layer 122 and the second tunneling layer 121 by using the alkaline solution, the second doped oxide layer 220 having a thickness of above 6 nm is reserved on the second region 102 by controlling the etching time, which can be capable of protecting the second tunneling layer 121 and the second doped layer 122 in subsequent patterning processing steps.

As shown in Fig. 6, the second tunneling layer 121 and the second doped layer 122 disposed on the first region 101 and the isolation region 103 are removed, and only the second tunneling layer 121, the second doped layer 122 and the second doped oxide layer 220 disposed on the second region 102 are reserved.

Fig. 7 is a schematic structural view of depositing the first tunneling layer 111 and the first doped layer 112 based on the structure shown in Fig. 6. As shown in Fig. 7, in the example, the first tunneling layer 111 and the first doped layer 112 cover the first region 101 and the isolation region 103 on the back side of the crystalline silicon substrate 100, and the first tunneling layer 111 and the first doped layer 112 further extend to cover the second tunneling layer 121 and the second doped layer 122.

As some examples of the embodiments, the first tunneling layer 111 and the first doped layer 112 include first tunneling layers 111 and first doped layers 112, which are stacked in sequence.

As some examples of the embodiments, forming the first tunneling layer 111 and the first doped layer 112 includes: sequentially depositing the first tunneling layer 111, a silicon material layer and the first doped oxide layer 210 by means of the chemical vapor deposition method, and performing heating to enable the doping element in the first doped oxide layer 210 to diffuse into the silicon material layer, so as to form the first doped layer 112, the chemical vapor deposition method specifically is LPCVD or PECVD.

For example, in the example, the material of the first doped oxide layer 210 is phosphosilicate glass, and due to the heating, a phosphorus element in the phosphosilicate glass diffuses into the silicon material layer to form N-type doped polycrystalline silicon, which serves as the first doped layer 112.

As some other examples of the embodiments, forming the first tunneling layer 111 and the first doped layer 112 includes: sequentially depositing the first tunneling layer 111 and the first doped layer 112 by means of the chemical vapor deposition method, the chemical vapor deposition method specifically is a plasma-enhanced chemical vapor deposition (PECVD) method, the first tunneling layer 111 and the first doped layer 112 are successively formed in the same deposition chamber, and after the first doped layer 112 is epitaxially deposited, a first doped oxide layer 210 is epitaxially deposited.

Step S2, removing a portion of the first doped oxide layer 210 in the light-trapping process region 301 with the first doped layer 112 disposed below the light-trapping process region being exposed.

It can be understood that the exposed first doped layer 112 is preferentially etched during subsequent etching process of the alkaline solution, so as to form the light-trapping valley 1102, and the portion of the first doped layer 112 that is still shielded by the first doped oxide layer 210 is etched relatively slowly, thereby forming the light-trapping peak 1101.

In the embodiments, removing a portion of the first doped oxide layer 210 in the light-trapping process region 301 includes: scanning the light-trapping process region 301 by using the target laser 310, during scanning the light-trapping process region 301 by using the target laser 310, a light spot of the target laser 310 includes a higher-energy region 311 and a lower-energy region 312, the power density of the higher-energy region 311 is greater than 0.25 J/cm², and the power density of the lower-energy region 312 is less than or equal to 0.25 J/cm²; or during scanning the light-trapping process region 301 by using the target laser 310, the target laser 310 is controlled to only scan a partial region of the light-trapping process region 301.

As some examples of the embodiments, the dimension of the light spot of the target laser 310 is in a range of 50 µm to 300 µm.

In the embodiments, when the target laser 310 scans the light-trapping process region 301, the first doped oxide layer 210 has a higher melting point and a higher light transmittance, therefore the target laser 310 actually acts mainly on the first doped layer 112, and after melting, the first doped layer 112 destroys the first doped oxide layer 210 disposed above the first doped layer 112, thereby achieving the purpose of removing the first doped oxide layer 210. By adjusting the energy distribution of the light spot of the target laser 310 (i.e., having the higher-energy region 311 and the lower-energy region 312), selective removal of the first doped oxide layer 210 is achieved; or, by changing the shape of the light spot of the target laser 310 that is disposed on the light-trapping process region 301, the target laser 310 can only scan a partial region of the light-trapping process region 301, thereby realizing the selective removal of the first doped oxide layer 210.

Fig. 8 is a schematic view of controlling energy density distribution of the light spot of the target laser 310. As shown in Fig. 8, as some examples of the embodiments, in the step of scanning the light-trapping process region 301 by using the target laser 310, the light spot of the target laser 310 includes the higher-energy region 311 and the lower-energy region 312, the power density of the higher-energy region 311 is greater than 0.25 J/cm², and the power density of the lower-energy region 312 is less than or equal to 0.25 J/cm². It can be understood that in Fig. 8, the target laser 310 is controlled to intermittently move along the light-trapping process region 301, the target laser 310 in the higher-energy region 311 removes the first doped oxide layer 210, and the target laser 310 in the lower-energy region 312 is difficult to remove the first doped oxide layer 210, thereby realizing the partial removal of the first doped oxide layer 210.

As some examples of the embodiments, the power density of the higher-energy region 311 of the target laser 310 is ranging from 0.25 J/cm² to 0.5 J/cm², for example, the power density of the higher-energy region 311 of the target laser 310 is any one of 0.25 J/cm², 0.28 J/cm², 0.3 J/cm², 0.32 J/cm², 0.35 J/cm², 0.38 J/cm², 0.4 J/cm², 0.45 J/cm² and 0.5 J/cm², or the power density of the target laser 310 is in an range of any two numerical values of the above power densities. By using the target laser 310 with the power density, it is more conducive to controlling the ablation degree of the target laser 310 for the first tunneling layer 111 and the first doped layer 112.

As some examples of the embodiments, the power density of the lower-energy region 312 of the target laser 310 is ranging from 0.13 J/cm² to 0.25 J/cm², for example, the power density of the lower-energy region 312 of the target laser 310 is 0.13 J/cm², 0.15 J/cm², 0.17 J/cm², 0.19 J/cm², 0.2 J/cm² and 0.22 J/cm², or the power density of the lower-energy region 312 of the target laser 310 is in an range of any two numerical values of the above power densities.

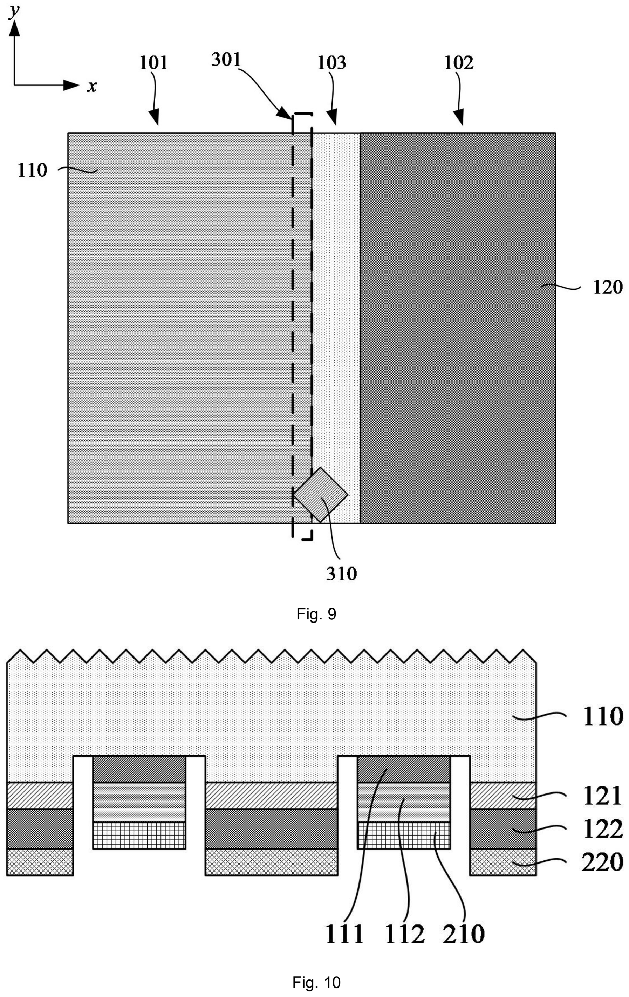

Fig. 9 is a schematic structural view of controlling a scanning region of the target laser 310. As shown in Fig. 9, as some other examples of the embodiments, during scanning the light-trapping process region 301 by using the target laser 310, the target laser 310 is controlled to only scan a partial region of the light-trapping process region 301.

As shown in Fig. 9, in the embodiments, during scanning the light-trapping process region 301 by using the target laser 310, the light spot of the target laser 310 takes the shape of a square, a rectangle or a diamond; and by rotating the light spot of the target laser 310, the target laser 310 covering the light-trapping process region 301 can be controlled to be triangular-shaped, and therefore the target laser 310 only irradiates onto a portion of the light-trapping process region 301 in the scanning process.

It can be understood that the above scanning manner by using the target laser 310 is only one way to remove a portion of the first doped oxide layer 210. During an actual processing steps, there are a plurality of manners for selectively removing a portion of the first doped oxide layer 210 from the light-trapping process region 301. For example, the surface of a portion of the first doped oxide layer 210 is damaged by mechanical processing, so as to remove the portion of the first doped oxide layer 210; or, a chemical etching manner is used, in which an etching agent is applied on the surface of the first doped oxide layer 210 by spot-applying or screen printing, so as to remove a portion of the first doped oxide layer 210.

As some examples of the embodiments, in the steps of forming the first tunneling layer 111, the first doped layer 112 and the first doped oxide layer 210, the formed first tunneling layer 111, the formed first doped layer 112 and the formed first doped oxide layer 210 are disposed on the isolation region 103 in an extension manner. The preparation method further includes performing laser-ablation in isolation region, so as to remove the first doped oxide layer 210 disposed on the isolation region 103.

For example, laser-ablation is performed in the isolation region, so as to remove the first doped oxide layer 210 disposed on the isolation region 103; and during the ablation process, the isolation region laser is switched to the target laser 310, and the target laser 310 irradiates the first doped oxide layer 210 on the light-trapping process region 301, the target laser 310 and the isolation region laser uses the same laser source or different laser sources.

As some examples of the embodiments, the power density of the isolation region laser is ranging from 0.25 J/cm² to 0.5 J/cm², for example, the power density of the isolation region laser is 0.25 J/cm², 0.28 J/cm², 0.3 J/cm², 0.32 J/cm², 0.35 J/cm², 0.38 J/cm², 0.4 J/cm², 0.45 J/cm² and 0.5 J/cm², or the power density of the isolation region laser is between any two numerical values of the above power densities.

As some examples of the embodiments, in the step of performing laser-ablation in the isolation region, the isolation region laser scans along the isolation region 103, and the overlapping ratio of the light spots of two adjacent isolation region lasers during the scanning process is 20% to 60%, that is, the light spots of the two adjacent isolation region lasers have an overlapping area of 20% to 60%, which can fully and uniformly remove the first tunneling layer 111 and the first doped layer 112 as much as possible.

The purpose of performing the laser-ablation in the isolation region laser is to remove the first doped oxide layer 210 on the isolation region 103; and the purpose of irradiating the target laser 310 is to partially remove the first doped oxide layer 210 on the light-trapping process region 301, so as to form the light-trapping valley 1102 and the light-trapping peak 1101 during the subsequent alkaline-etching processing.

As some examples of the embodiments, in the step of performing laser-ablation in the isolation region to remove the first tunneling layer 111 and the first doped layer 112, the first doped oxide layer 210, the first tunneling layer 111 and the first doped layer 112 disposed on the second region 102 are also ablated as well.

Step S3, etching the first doped oxide layer 210, the first doped layer 112 and the first tunneling layer 111 in alkaline solution, so as to form the light-trapping portion 1100.

Fig. 10 is a schematic view of a cross-sectional structure after the structure shown in Fig. 7 is etched by the alkaline solution. As shown in Fig. 10, during the process of etching the first doped oxide layer 210, the first doped layer 112 and the first tunneling layer 111 by using the alkaline solution, since only a portion of the first doped oxide layer 210 on the light-trapping process region 301 is removed, the exposed first doped layer 112 and the first tunneling layer 111 are etched relatively faster, and the other unexposed first doped layer 112 and the first tunneling layer 111 are etched relatively slowly, so that at least one of the light-trapping valley 1102 and the light-trapping peak 1101 can be formed.

In the embodiments, an N-type first doped layer 112 is more easily etched by the alkaline solution, so that a light-trapping structure is prepared on the basis of the N-type first doped layer 112, which has the advantage of lower process difficulty. In other embodiments, the light-trapping structure is prepared by using a P-type first doped layer 112.

As some examples of the embodiments, in the step of etching the first tunneling layer 111 and the first doped layer 112 by using the alkaline solution, a texturing agent is used as the alkaline solution, and meanwhile, a texturing treatment is performed on the front side of the crystalline silicon substrate 100 by using the texturing agent. The texturing agent is an alkaline texturing agent for forming a textured structure, which includes sodium hydroxide and a texturing additive. By using the texturing agent as the alkaline solution, not only can the light-trapping portion 1100 be formed, but textured structures can also be formed on the surface of the isolation region 103 of the crystalline silicon substrate 100 and the front side of the crystalline silicon substrate 100.

During the process of forming the light-trapping portion 1100, the remaining first doped oxide layer 210 and the remaining second doped oxide layer 220 are removed, that is, the first tunneling layer 111 and the first doped layer 112 disposed on the first region 101, and the second tunneling layer 121 and the second doped layer 122 disposed on the second region 102 are exposed. In addition, the problem of wrapping-around deposition occurs during the process of depositing the film layers, and the wrapping-around depositing materials are removed together during the alkaline processing.

As some examples of the embodiments, after forming the light-trapping portion 1100 by the corrosion of the alkaline solution, the method further includes depositing the first passivation layer 113, the second passivation layer 123 and the front-side passivation layer 130.

As some examples of the embodiments, after depositing the first passivation layer 113, the second passivation layer 123 and the front-side passivation layer 130, the method further includes depositing the first anti-reflection layer 114, the second anti-reflection layer 124 and the front-side anti-reflection layer 140.

As some examples of the embodiments, after forming the first passivation layer 113 and the second passivation layer 123, the method further includes preparing the first electrode 150 and the second electrode 160. The manner of preparing the first electrode 150 and the second electrode 160 includes screen printing, electroplating, and PVD (Physical Vapor Deposition).

By adopting the step S1 to the step S3, the back-contact solar cell of the present invention is formed.

In some embodiments, the present invention further provides a photovoltaic module, the photovoltaic module includes the back-contact solar cell in accordance with any of the above embodiments, or the photovoltaic module includes a back-contact solar cell prepared by the preparation methods of the back-contact solar cell in accordance with any of the above embodiments.

In some embodiments, the present invention further provides the following elaborate embodiments and comparative examples to further illustrate the specific implementations of the present invention and corresponding beneficial effects.

### Embodiment 1

Crystalline silicon is used as a crystalline silicon substrate, silicon dioxide having a thickness of 2 nm is deposited on the back side of the crystalline silicon substrate by using LPCVD to serve as a second tunneling layer, then intrinsic amorphous silicon having a thickness of 300 nm and borosilicate glass having a thickness of 50 nm are deposited, and P-type doped polycrystalline silicon is formed by a high-temperature annealing treatment to serve as a second doped layer.

The borosilicate glass of a first region and an isolation region is etched by using laser, and then the second doped layer and the second tunneling layer of the first region and the isolation region are etched by using an alkaline solution, until the crystalline silicon substrate is exposed.

Silicon dioxide having a thickness of 2 nm is deposited on the backside of the crystalline silicon substrate by using LPCVD to serve as a first tunneling layer, then intrinsic amorphous silicon having a thickness of 300 nm and phosphosilicate glass having a thickness of 50 nm are deposited, and N-type doped polycrystalline silicon is formed by the high-temperature annealing treatment to serve as a first doped layer.

The laser is used to scan the isolation region in accordance with the preset pattern, so as to ablate the second region and the isolation region, and target laser is used for ablating the first region close to the isolation region, a light spot of the target laser and a light spot of the isolation region laser are both square-shaped. The target laser irradiated on the first region has a higher-energy region and a lower-energy region, and the power density of the higher-energy region is 0.3 J/cm², the power density of the lower-energy region is 0.15 J/cm². Along a boundary line between the isolation region and the first region, the target laser irradiates once every 100 µm, the target laser extends 25 µm along the boundary line during every irradiation, and the target laser extends 15 µm inwards the first region. The power density of the isolation region laser is 0.4 J/cm², and the laser energy of the isolation region is uniformly distributed.

A wrapping-around depositing materials on the surface of the crystalline silicon substrate are removed, the front side of the crystalline silicon substrate, the isolation region and a region scanned by the target laser are treated by using a texturing agent, so that textured structures are formed onto the front side of the crystalline silicon substrate and the surface of the isolation region, and a light-trapping valley and a light-trapping peak are formed in the region scanned by the target laser.

An aluminum oxide passivation layer and a hydrogenated silicon nitride anti-reflection layer are respectively deposited on the front side and the back side of the crystalline silicon substrate, and a positive electrode and a negative electrode are printed on the back side of the crystalline silicon substrate by means of screen printing.

### Comparative Example 1

Comparative Example 1 is basically the same as Embodiment 1, and the main difference lies in that in Comparative Example 1, only the isolation region is laser-scanned, the target laser is not used for scanning, and thus the light-trapping portion is not formed.

Test 1: the isolation region in Embodiment 1 and the surface morphology of the isolation region close to the first region are observed by using a scanning electron microscope, and observation results are shown in Figs. 11-13, Fig. 11 is an enlarged partial top view including one light-trapping portion in Embodiment 1, Fig. 12 is a reduced partial top view including a plurality of light-trapping portions in Embodiment 1, and Fig. 13 is a schematic view of a cross-sectional structure of Embodiment 1.

Test 2: the electrical performance of the above embodiments is tested, and the specific results are shown in Table 1.

**Table 1 Electrical performance test of Embodiment 1 and Comparative Example 1**

| | Open-circuit voltage (V) | Short-circuit current density (mA/cm²) | Fill factor | Conversion efficiency |
|---|---|---|---|---|
| Embodiment 1 | 0.7426 | 42.832 | 82.36% | 26.20% |
| Comparative Example 1 | 0.7415 | 42.690 | 82.17% | 26.01% |

As shown in Fig. 11, in the back-contact solar cell prepared in Embodiment 1, a textured structure is formed onto the surface of the isolation region 103. One side of the isolation region 103 is designed to be a first region, in which film layers are provided in the first region, and the film layers is a passivation contact layers composed of N-type doped polycrystalline silicon and a silicon dioxide layer. A light-trapping portion 1100 is formed in the passivation contact layers, and the light-trapping portion 1100 is provided with a plurality of light-trapping valley 1102 and a plurality of continuous light-trapping peaks 1101.

As shown in Fig. 12, a white dotted line in Fig. 12 represents a reference line of the isolation region 103, 183 points disposed on the first boundary 1001 are acquired in Fig. 12 by means of an automatic identification function of GetData Software, and distances of the 183 points relative to the reference line in the isolation region 103 are respectively acquired, and a variance of the distances is calculated to be 52.85. 183 points disposed on the second boundary 1002 are acquired in Fig. 12, distances of the 183 points relative to the reference line of the isolation region 103 are respectively acquired, and a variance of the distances is calculated to be 27.27. Therefore, the fluctuation variance of the first boundary 1001 is obviously greater than the fluctuation variance of the second boundary 1002. It should be noted that, when the points on the first boundary and the second boundary are automatically identified by using GetData software, as long as the points are uniformly distributed in a direction along the reference line of the isolation region, it represents the deviation degree of the first boundary or the second boundary relative to the reference line of the isolation region, the number of the points of the first boundary is not equal to the number of the points of the second boundary, and in general, it is a relatively reasonable point sampling manner in which the ratio of the number of the points of the first boundary to the number of the points of the second boundary ranges from 0.5 to 2.

As shown in Fig. 13, a height difference between a bottommost end of the light-trapping portion 1100 and the top surface of the first functional film 110 in Fig. 13 is 3.92 µm, the isolation region 103 has a textured structure, a height difference between the bottommost end of the textured structure and the top surface of the first functional film 110 is 2.85 µm, which indicates that the height difference between the bottommost end of the light-trapping portion 1100 and the top surface of the first functional film 110 is greater than the height difference between the bottommost end of the isolation region 103 and the top surface of the first functional film 110.

As shown in Table 1, in Comparative Example 1, a conventional manner is used, and the target laser is not used for irradiation, so that the light-trapping portion is not formed. Compared with Comparative Example 1, the target laser in Embodiment 1 is used for irradiation to form the trapping portion, so that both the short circuit current density and the conversion efficiency in Embodiment 1 are obviously improved.

It is noted that the above embodiments are for illustrative purposes only and are not intended to limit the present invention.

It should be understood that unless explicitly stated herein, the execution sequence of the steps is not strictly limited, and these steps are executed in other sequences. Moreover, at least a portion of the steps in the preparation process include a plurality of sub-steps or a plurality of stages, and these sub-steps or stages are not necessarily executed at the same moment, but are executed at different moments, and the these sub-steps or stages is not necessarily executed in sequence, but is executed in turn or alternately with other steps or at least a portion of the sub-steps or stages of the other steps.

The embodiments in the present specification are described in a progressive manner, each embodiment focuses on the differences from other embodiments, and the same or similar portions between the embodiments are referred to each other.

The technical features of the above embodiments are combined arbitrarily. In order to make the description concise, all possible combinations of the technical features in the above embodiments are not described. However, as long as there is no contradiction in the combinations of these technical features, the combinations should be considered as the scope recorded in the present specification.

## Claims

1. A back-contact solar cell, comprising:
a crystalline silicon substrate (100), wherein a back side of the crystalline silicon substrate (100) is provided with a first region (101), a second region (102) and an isolation region (103), the isolation region (103) is disposed between the first region (101) and the second region (102), and the first region (101) and the second region (102) are spaced apart by the isolation region (103);
a first functional film (110), wherein the first functional film (110) comprises a first tunneling layer (111) and a first doped layer (112), the first tunneling layer (111) and the first doped layer (112) are sequentially stacked on the first region (101), the first functional film (110) is provided with a light-trapping portion (1100) close to the isolation region (103), the light-trapping portion (1100) is provided with at least one of a light-trapping valley (1102) and a light-trapping peak (1101), and along a direction close to the crystalline silicon substrate (100), the light-trapping valley (1102) spatially narrows, and the light-trapping peak (1101) expands outwardly; and
a second functional film (120), wherein the second functional film (120) comprises a second tunneling layer (121) and a second doped layer (122), the second tunneling layer (121) and the second doped layer (122) are sequentially stacked on the second region (102), and the second doped layer (122) and the first doped layer (112) have opposite doping types.

2. The back-contact solar cell according to claim 1, wherein the light-trapping portion (1100) comprises a plurality of light-trapping peaks (1101), the plurality of light-trapping peaks (1101) are continuously disposed, and bottommost ends of side walls (1103) of two adjacent light-trapping peaks (1101) of the plurality of light-trapping peaks (1101) are connected.

3. The back-contact solar cell according to claim 1 or 2, wherein the first functional film (110) has a first boundary (1001) close to the isolation region (103), the second functional film (120) has a second boundary (1002) close to the isolation region (103), and a fluctuation variance of the first boundary (1001) is greater than a fluctuation variance of the second boundary (1002).

4. The back-contact solar cell according to any one of the preceding claims, wherein the first functional film (110) has a first boundary (1001) close to the isolation region (103), a value of a fluctuation variance of the first boundary (1001) is in a range of 30 to100.

5. The back-contact solar cell according to any one of the preceding claims, wherein a height difference between an end portion of the light-trapping portion (1100) that is closest to the crystalline silicon substrate (100) and a top surface of the first functional film (110) is in a range of 0.5 µm to 6 µm.

6. The back-contact solar cell according to any one of the preceding claims 1 to 4, wherein a height difference between an end portion of the light-trapping portion (1100) that is closest to the crystalline silicon substrate (100) and the top surface of the first functional film (110) is in a range of 3 µm to 6 µm.

7. The back-contact solar cell according to any one of the preceding claims, wherein a surface of the isolation region (103) of the crystalline silicon substrate (100) has a textured structure, and a height difference between a bottommost end of the light-trapping portion (1100) and a top surface of the first functional film (110) is greater than a height difference between a bottommost end of the insolation region adjacent to the light-trapping portion and the top surface of the first functional film (110).

8. The back-contact solar cell according to any of claims 1-7, wherein a doping type of the first doped layer (112) is an N type, and a doping type of the second doped layer (122) is a P type.

9. The back-contact solar cell according to any of claims 1-7, wherein the back-contact solar cell satisfies at least one of :
the first functional film (110) further comprises at least one of a first passivation layer (113) and a first anti-reflection layer (114) which are stacked on the first doped layer (112); and,
the second functional film (120) further comprises at least one of a second passivation layer (123) and a second anti-reflection layer (124) which are stacked on the second doped layer (122).

10. A preparation method of the back-contact solar cell according to any of claims 1-9, comprising the following steps:
sequentially forming the second tunneling layer (121) and the second doped layer (122) on the second region (102) of the crystalline silicon substrate (100), and sequentially forming the first tunneling layer (111), the first doped layer (112) and a first doped oxide layer (210) on the first region (101) of the crystalline silicon substrate (100);
the first doped oxide layer (210) is provided with a light-trapping process region (301) close to the isolation region (103), removing a portion of the first doped oxide layer (210) in the light-trapping process region (301), with the first doped layer (112) disposed below the light-trapping process region (301) being exposed; and
etching the first doped oxide layer (210), the first doped layer (112) and the first tunneling layer (111) by using an alkaline solution, so as to form the light-trapping portion (1100).

11. The preparation method of the back-contact solar cell according to claim 10, wherein removing the portion of the first doped oxide layer (210) in the light-trapping process region (301) comprises: scanning the light-trapping process region (301) by using target laser (310), wherein
during scanning the light-trapping process region (301) by using target laser (310), a light spot of the target laser (310) comprises a higher-energy region (311) and a lower-energy region (312), wherein a power density of the higher-energy region (311) is greater than 0.25 J/cm², and a power density of the lower-energy region (312) is less than or equal to 0.25 J/cm²; or,
during scanning the light-trapping process region (301) by using target laser (310), the target laser (310) is controlled to only scan a partial region of the light-trapping process region (301).

12. The preparation method of the back-contact solar cell according to any of claims 10-11, wherein in a step of forming the first tunneling layer (111) and the first doped layer (112) on the crystalline silicon substrate (100), the first tunneling layer (111), the first doped layer (112) and the first doped oxide layer (210) are epitaxially deposited on the isolation region (103) in an extension manner; and
the preparation method further comprises a step of performing laser-ablation in the isolation region, so as to remove the first doped oxide layer (210) disposed on the isolation region (103).

13. The preparation method of the back-contact solar cell according to any of claims 10-11, wherein in a step of etching the first tunneling layer (111) and the first doped layer (112) by using the alkaline solution, a texturing agent is used as the alkaline solution, and meanwhile a texturing treatment is performed on a front side and the back side of the crystalline silicon substrate (100) by using the texturing agent.

14. A photovoltaic assembly, wherein the photovoltaic assembly comprises the back-contact solar cell according to any of claims 1-9;
or the photovoltaic assembly comprises the back-contact solar cell prepared by the preparation method of the back-contact solar cell according to any of claims 10-13.
